(19) Europäisches Patentamt
European Patent Office
Office européen des brevets

(11) **EP 0 821 471 B1**

(12) **EUROPÄISCHE PATENTSCHRIFT**

(45) Veröffentlichungstag und Bekanntmachung des Hinweises auf die Patenterteilung:
**11.10.2000 Patentblatt 2000/41**

(51) Int Cl.$^7$: **H03F 1/02**

(21) Anmeldenummer: **97110155.5**

(22) Anmeldetag: **20.06.1997**

(54) **Vorrichtung zur selbst-justierenden Arbeitspunkt-einstellung in Verstärker-schaltungen mit Neuron-MOS-Transistoren**

Device for self-aligning the adjustment of the bias working point in amplifier circuits with Neuron-MOS transistors

Dispositif pour auto-aligner le réglage du point de fontionnement d'amplificateurs à transistors MOS-Neurones

(84) Benannte Vertragsstaaten:
**DE FR GB IT**

(30) Priorität: **25.07.1996 DE 19630111**

(43) Veröffentlichungstag der Anmeldung:
**28.01.1998 Patentblatt 1998/05**

(73) Patentinhaber: **SIEMENS AKTIENGESELLSCHAFT**
**80333 München (DE)**

(72) Erfinder:
• **Thewes, Roland, Dr.**
  **82194 Gröbenzell (DE)**
• **Weber, Werner, Dr.**
  **80637 München (DE)**
• **Schmitt, Landsiedel, Dories, Dr.**
  **85521 ottobrunn (DE)**
• **Luck, Andreas**
  **81737 München (DE)**

(56) Entgegenhaltungen:
**EP-A- 0 516 847      WO-A-95/15581**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 821 471 B1

**Beschreibung**

Insbesondere für großsignalmäßig lineare Verstärkerschaltungen mit Neuron-MOS-Transistoren besteht ein großes Potential für viele Analogschaltungsapplikationen, wie zum Beispiel Video- und Audioanwendungen, in der Sensorik, in Analogrechnern, in Fuzzy-Schaltungen und Neuronalen Netzen.

Aus den IEEE Transactions on Electron Devices, Vol. 39, No. 6, June 1992 ist der Aufbau und die Funktionsweise eines Neuron-MOS-Transistors und seine Verwendung als Verstärker bekannt.

Wird mit Hilfe eines Neuron-MOS-Transistors ein großsignalmäßig linearer Verstärker bzw. Summier-Verstärker realisiert, weist dieser in der Regel in seiner Übertragungskennlinie eine undefinierte Nullpunktsverschiebung bzw. eine Verschiebung des Arbeitspunktes auf, die beispielsweise auf eine prozeßbedingte Aufladung des Floating-Gates des Neuron-MOS-Transistors zurückzuführen ist.

Die der Erfindung zugrundeliegende Aufgabe besteht nun darin, Vorrichtungen anzugeben, bei denen bei mindestens einer solchen Verstärkerstufe eine definierte Nullpunktspannung abhängig von einem einstellbaren Sollwert für die Nullpunktspannung mit möglichst geringem Bauelementeaufwand ermöglicht wird. Diese Aufgabe wird erfindungsgemäß durch die Merkmale des Anspruchs 1 gelöst. Vorteilhafte Ausbildungen der erfindungsgemäßen Vorrichtung ergeben sich aus den Unteransprüchen.

Die Erfindung wird im folgenden anhand der Zeichnungen näher erläutert. Dabei zeigt

Figur 1 einen großsignalmäßig linearen Verstärker mit Neuron-MOS-Transistor,

Figur 2 eine schematische Darstellung des Übertragungsverhaltens des Verstärkers aus Figur 1 zur Erläuterung der Nullpunktsverschiebung,

Figur 3 eine erste Ausbildung der erfindungsgemäße Vorrichtung mit k Verstärkern nach Figur 1,

Figur 4 eine zweite Ausbildung der erfindungsgemäße Vorrichtung mit k Verstärkern nach Figur 1,

Figur 5 eine dritte Ausbildung der erfindungsgemäße Vorrichtung auf der Basis eines Verstärkers nach Figur 1.

Figuren 6 und 7 Ausführungsbeispiele für den Mehrfachstromspiegel SS in den Figuren 3 und 4 und

Figur 8 ein Ausführungsbeispiel für eine anstelle des Strmspiegels SS in Figur 4 ebenfalls mögliche Mehrfachstromquellenschaltung.

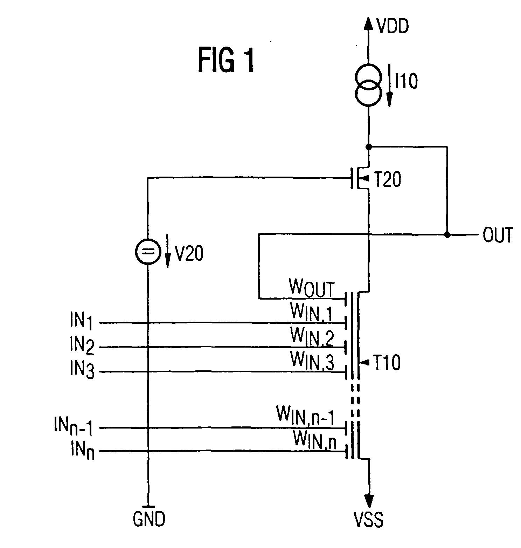

Figur 1 zeigt eine großsignalmäßig lineare Verstärkerschaltung mit einem Neuron-MOS-Transistor, die n Eingänge aufweist. Ihre Übertragungsfunktion lautet bei symmetrischen Versorgungsspannungen

$$V_{OUT} = \frac{1}{w_{OUT}} \times V_0 - \sum_{i=1}^{n} \frac{w_{IN,i}}{w_{OUT}} \times V_{IN,i} \tag{1}$$

Dabei steht $V_{OUT}$ für die Ausgangsspannung der Schaltung, $V_{IN,i}$ für die Eingangsspannung am i-ten Eingang der Schaltung $IN_i$. Die Parameter $w_{IN,i}$ stehen für die sogenannte Wichtung der jeweiligen Koppel-Gates, die sich über das Verhältnis aus Koppelkapazität $C_{IN,i}$ zwischen Eingang $IN_i$ und dem Floating-Gate und der Summe $C_{ges}$ aller Kapazitäten, deren eine Elektrode das Floating-Gate darstellt, berechnet:

$$W_{IN,i} = \frac{C_{IN,i}}{C_{ges}} \tag{2}$$

mit

2

$$C_{ges} = C_{FG} + \sum_{i=1}^{n} C_{IN,i} \qquad (3)$$

Der Parameter $C_{FG}$ in Gleichung (3) steht dabei für die Kapazität zwischen dem Floating-Gate und dem Kanalbereich einschließlich der Source-Drain-Überlappkapazitäten. Eine analoge Definition wie für die Parameter $w_{IN,i}$ gilt für den Parameter $w_{OUT}$, der die Wichtung des mit dem Vertärkerausgang OUT verbundenen Koppel-Gates darstellt.

Werden noch eine mögliche prozeßbedingte Aufladung des Floating-Gates auf ein Potential $V_{QP}$ und ein über den Kanalbereich eingekoppelter Potentialbeitrag $V_{CH}$ mit berücksichtigt, so ergibt sich ein Floating-Gate-Pegel

$$V_{FG} = V_{QP} + \sum_{i=1}^{n} w_{IN,i} \times V_{IN,i} + w_{OUT} \times V_{OUT} + V_{CH} \qquad (4)$$

Durch Auflösung dieser Gleichung nach $V_{OUT}$ und Zusammenfassung der Spannungen $V_{FG}$, $V_{QP}$ und $V_{CH}$ zur Nullpunktsspannung

$$V_0 = V_{FG} - V_{QP} - V_{CH} \qquad (5)$$

ergibt die Gleichung (1).

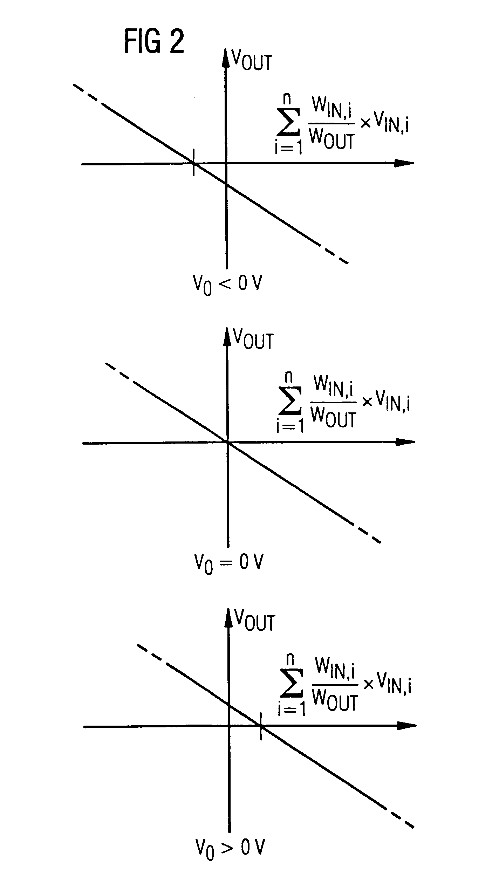

In Figur 2 ist die Ausgangsspannung VOUT gemäß Gleichung (1) als Funktion der gewichteten Summe der Eingangssignale für verschiedene Werte $V_0$ schematisch skizziert. Die Nullpunkts-Spannung $V_0$ gibt dabei den Achsenabschnitt an, bei dem die Übertragungsfunktion gemäß Gleichung (1) die Ordinate schneidet, auf der hier die gewichtete Summe der Eingangssignale aufgetragen ist. In vielen Anwendungen ist es wünschenswert bzw. notwendig, der Nullpunkts-Spannung $V_0$ einen bestimmten Wert zuweisen zu können. In vielen Anwendungen wird das der Wert $V_0 = 0$ V sein. Dies entspricht einer Einstellung des Arbeitspunktes der Verstärkerschaltungen bzw. einem Abgleich des DC-Anteiles der Übertragungsfunktion gemäß Gleichung (1).

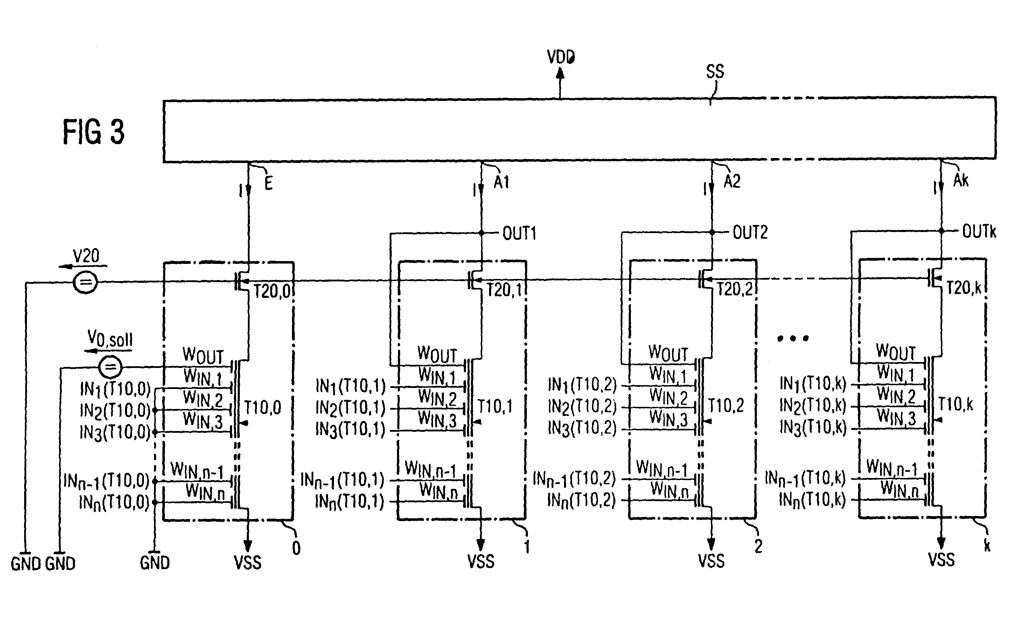

Figur 3 stellt beispielhaft eine erste Ausbildung der erfindunggemäßen Vorrichtung dar, bei der identische Blöcke 0...k aus jeweils einer Reihenschaltung eines n-Kanal-MOS-Transistors T20,0 ...T20,k und eines jeweiligen Neuron-Mos-Transistors T10,0...T10,k sowie eine Mehrfach-Stromspiegelschaltung SS vorgesehen sind. Alle Gates der Transistoren T20,0...T20,k sind mit einer Spannungsquelle V20 beschaltet und ein jeweiliger erster Anschluß der Blöcke, der gleichzeitig einen ersten Anschluß des Neuron-MOS-Transistors bildet, ist mit der negativen Versorgungsspannung VSS verbunden. Der zweite Anschluß des Blocks 0, der gleichzeitigen einen zweiten Anschluß des n-Kanal-MOS-Transistors T20,0 bildet, ist mit einem Eingang E des Mehrfach-Stromspiegels SS verbunden. Die jeweils zweiten Anschlüsse, die gleichzeitig die zweiten Anschlüsse der jeweiligen n-Kanal-MOS-Transistoren T20,1 ...T20,k bilden, sind mit den jeweiligen Ausgängen A1...Ak des Mehrfachstromspiegels verbunden. Der Block 0 ist so beschaltet, daß das Gate des Neuron-MOS-Transistors mit der Ausgangswichtung $w_{out}$ den Sollwert $V_{0,soll}$ der Nullpunktsspannung und alle Gates mit den Eingangswichtungen $w_{IN,1}...w_{IN,n}$ Bezugspotential erhalten. Der so beschaltete Block 0 bildet eine gesteuerte Stromsenke, die einen vom vorgegebenen Sollwert $V_{0,soll}$ der Nullpunktspannung abhängigen Strom I am Eingang E zieht.

Sofern die Blöcke 0..k alle das gleiche Layout aufweisen, die Topologie der näheren Umgebung der Blöcke 0..k identisch ist und die Entfernung dieser Blöcke zueinander auf dem Chip nicht allzu groß ist, kann davon ausgegangen werden, daß die durch die prozeßbedingte Aufladung des Floating-GAtes bedingte Spannung $V_{QP}$ in den Gleichungn(4) und (5) für alle Stufen bzw. Neuron-MOSFETs T10,0 ... T10,k gleich ist. Unter der Bedingung, daß alle Verstärkerstufen mit dem gleichen Querstrom I betrieben werden, bedeutet das, daß sich für alle Stufen die gleiche Spannung $V_0$ einstellt.

Unter der Bedingung

$$\sum_{i=1}^{n} \frac{w_{IN,i}}{w_{OUT}} \times V_{IN,i}(T10, j) = 0 \qquad\qquad (7)$$

nämlich, daß an den Eingängen einer Verstärkerstufe j = 1 ... k der Beitrag der Eingangssignale $V_{IN,i}$ (T10,j) identisch mit dem Beitrag der Eingangssignale $V_{IN,i}$ (T10,0) in Block 0, nämlich 0 ist, muß sich am Ausgang einer Verstärkerstufe, für die Gleichung (7) erfüllt ist, zwangsläufig die Spannung $V_{OUT}=V_{0,soll}$ einsstellen, da sich der jeweilige Neuron-MOS-Transistor T10,j einer Verstärkerstufe j=1..k dann exakt in dem gleichen Arbeitspunkt befindet wie der Neuron-MOS-Transistor T10,0 im Block 0.

Die weiter oben eingeführten Voraussetzungen stellen praktisch keine Einschränkung dar, da für eine gegebene Verstärkerstufe, deren Neuron-MOS-Transistor in bestimmter Weise konfiguriert ist, durch Layoutmaßnahmen, nämlich durch eine Kopie eines Blockes und eine entsprechende Änderung der Beschaltung der Koppel-Gates, immer eine geeignete Stromsenke aufgebaut werden kann.

Sofern mehrere Verstärkerstufen innerhalb einer Schaltung eingesetzt werden, die jedoch alle anders konfiguriert sind oder aber die aus bestimmten Gründen auf dem Chip sehr weit voneinander entfernt liegen, muß zu jeder Verstärkerschaltung eine eigene Stromsenke mit aufgebaut werden. Auch in diesem Falle bleiben die Vorteile von Neuron-MOS-Verstärkern, nämlich insbesondere deren geringer Platz- und Leistungsverbrauch, gegenüber bekannten Lösungen erhalten.

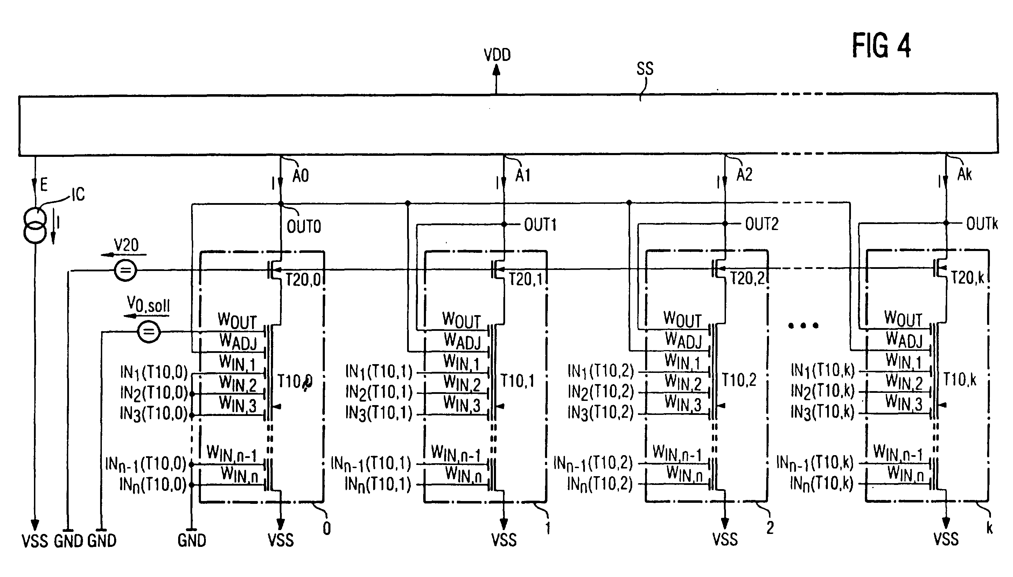

In Figur 4 ist eine zweite Ausbildung der Erfindung gezeigt, die sich von der in Figur 3 dargestellten dadurch unterscheidet, daß für die Neuron-MOS-Transistoren T10,0 ... T10,k jeweils ein zusätzliches Gate mit einer Justier-Wichtung $w_{ADJ}$ vorgesehen ist und alle diese zusätzlichen Gates mit einem zusätzlichen Ausgang A0 des Stomspiegels SS verbunden sind, daß beim Block 0 der Anschluß des Transistors T20,0 nicht mit dem Stromspiegeleingang E sondern mit dem zusätzlichen Ausgang A0 verbunden ist und daß anstelle des Blocks 0 eine Konstantstromsenke I0 einen Strom I zieht.

Aus schaltungstechnischer Sicht unterscheiden sich die Schaltungen aus Figur 3 und Figur 4 hinsichtlich ihres Funktionsprinzips dadurch, daß die Stufe 0 in Figur 3 selber einen Referenzstrom generiert, welcher dann über den Stromspiegel SS möglichst exakt gespiegelt und den Stufen 1 ... k eingeprägt werden muß. In Figur 4 hingegen wird allen Stufen, d. h. den Stufen 1 ... k und insbesondere auch der Referenzstufe 0 ein für alle Stufen gleicher, anderweitig vorgegebener Strom eingeprägt. Hier kann die Stufe 0 demnach nicht als Referenzstrom-Generator arbeiten, da ihr ein Strom vorgegeben ist, sondern sie funktioniert als Referenzspannungs-Generator, wobei die von ihr erzeugte Referenzspannung wie oben beschrieben den weiteren Stufen 1 ... k zugeführt wird. Dieser Unterschied hat Konsequenzen bzgl. der Anforderungen an den Stromspiegel SS:

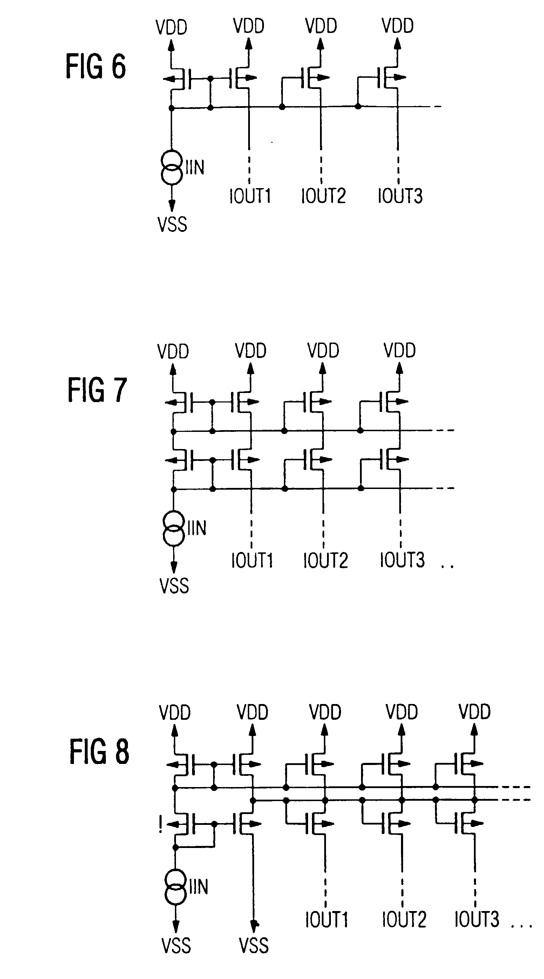

Während in Figur 3 eine Schaltung SS vonnöten ist, welche exakt Stromspiegelcharakter hat, muß in der Schaltung gemäß Figur 4 lediglich die Anforderung erfüllt sein, daß eine Stromquellenschaltung vorliegt, die an allen ihren Ausgängen den gleichen Strom zur Verfügung stellt. Das bedeutet insbesondere, daß in Figur 4 prinzipiell alle Schaltungen anstelle eines exakten Stromspiegels SS verwendet werden können, die mit Hilfe einer beliebigen Referenzgröße k+1 gleiche Ausgangsströme produzieren, die den Stufen 0 ... k zugeführt werden. Dabei genügt es, wenn der funktionale Zusammenhang zwischen der Referenzgröße und den Ausgangsströmen nur ungefähr bekannt ist und nicht durch ein exaktes Spiegelverhältnis beschrieben wird. Wie später noch im Zusammenhang mit den Figuren 6 - 8 diskutiert wird, gibt es Schaltungen, die aus einem eingangsseitig eingeprägten Strom die Referenz für exakt gleiche Ausgangsströme ableiten, das Verhältnis zwischen Eingangsstrom und Ausgangsstrom jedoch nicht exakt die von Stromspiegelschaltungen verlangte Charakteristik aufweist.

Die Aufnahme eines solchen zusätzlichen Koppel-Gates mit der Wichtung $W_{ADJ}$ in einen Neuron-MOS-Verstärker gemäß Figur 1 bewirkt zwar, daß die Absolutwerte der Wichtungen $w_{IN,i}$ mit i = 1 ... n und $w_{OUT}$ sich verringern, die Verhältnisse $w_{IN,i}/W_{IN,m}$ (i, m = 1 ... n) bzw. $w_{IN,i}/w_{OUT}$ (i = 1 ... n) bleiben jedoch gewahrt.

Diese Beschaltung bewirkt, daß die Spannung $V_0$ in der Übertragungsfunktion aller Verstärkerstufen 1 ... k wie gewünscht den Sollwert $V_{0,soll}$ annimmt, was durch die folgende Berechnung bewiesen wird:

Wenn das Gleichungssystem (1) ... (5) auf den hier vorliegenden Fall der um ein weiteres Koppel-Gate mit der Wichtung $w_{ADJ}$ erweiteren Verstärkerstufen in Figur 4 modifizieren, ergeben sich für die Verstärkerstufen in den Blöcken 1...k folgende Ausgangsspannungen

$$V_{OUT,j} = \frac{1}{w_{OUT}} \times V_0 - \frac{w_{ADJ}}{w_{OUT}} \times V_{OUT,0} - \sum_{i=1}^{n} \frac{w_{IN,i}}{w_{OUT}} \times V_{IN,i}(T10,j) \qquad (8)$$

mit

$$W_{IN,i} = \frac{C_{IN,i}}{C_{ges}} \, , \; w_{ADJ} = \frac{C_{ADJ}}{C_{ges}} \, , \; w_{OUT} = \frac{C_{OUT}}{C_{ges}} \qquad (9)$$

und

$$C_{ges} = C_{FG} + C_{ADJ} + \sum_{i=1}^{n} C_{IN,i} \qquad (10)$$

Die Gleichungen (9) und (10) gelten für T10,0 ebenso, die zu Gleichung (8) analoge Beziehungen, das heißt die Übertragungsfunktion von T10,0, lautet:

$$V_{OUT,0} = \frac{1}{w_{ADJ}} \times V_0 - \frac{w_{OUT}}{w_{ADJ}} \times V_{0,soll} - \sum_{i=1}^{n} \frac{w_{IN,i}}{w_{ADJ}} \times V_{IN,i}(T10,0) \qquad (11)$$

Da die Eingänge $IN_i(T10,0)$ alle mit dem GND-Potential = 0 V verbunden sind, liefert die Summe in Gleichung (11) keinen Beitrag, so daß Gleichung (11) vereinfacht werden kann zu

$$V_{OUT,0} = \frac{1}{w_{ADJ}} \times V_0 - \frac{w_{OUT}}{w_{ADJ}} \times V_{0,soll} \qquad (12)$$

Einsetzen von Gleichung (12) in Gleichung (8) liefert

$$V_{OUT,j} = V_{0,soll} - \sum_{i=1}^{n} \frac{w_{IN,i}}{w_{OUT}} \times V_{IN,i}(T10,j) \qquad (13)$$

also die gewünschte Übertragungsfunktion für die Verstärkerstufen 1 ... k.

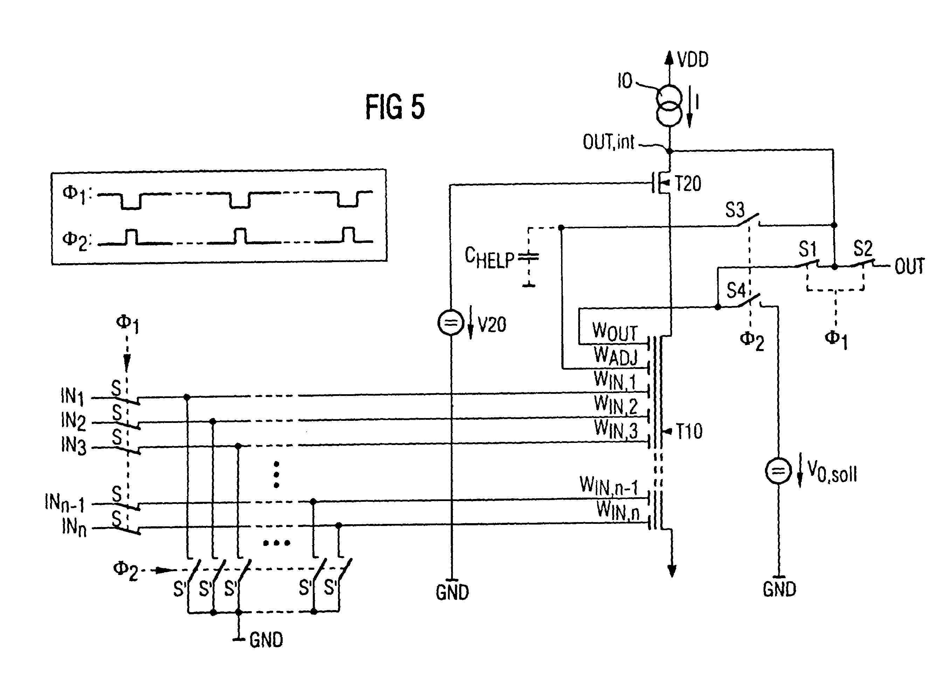

Figur 5 zeigt eine dritte Ausbildung der erfindungsgemäßen Vorrichtung, bei der der Gleichspannungsanteil der Übertragungsfunktion bzw. die Nullpunktsspannung $V_0$ mittels periodisch durchgeführter Rückführung und Subtraktion der Ausgangsspannung erfolgt. Ähnlich wie in Figur 4 ist der Neuron-MOSFET T10 der Verstärkerstufe gegenüber der Verstärkerstufe von Figur 1 um ein zusätzliches Koppel-Gate mit der Wichtung $w_{ADJ}$ erweitert. Die Wichtung $w_{ADJ}$ ist dabei genauso groß wie die Wichtung $w_{OUT}$.

Parallel zum Koppel-Gate mit der Wichtung $w_{ADJ}$ kann eine Kapazität $C_{HELP}$ gegen GND oder gegen einen anderen konstanten Spannungspegel angeschlossen sein, die der Speicherung eines Spannungswertes dient. Diese Maßnahme ist jedoch für das Funktionsprinzip nicht zwingend erforderlich, da auch das Koppel-Gate mit der Wichtung $w_{ADJ}$ allein schon als Speicherkapazität dienen kann.

Zwischen die Eingänge $IN_1$ ... $IN_n$ und die zugehörigen Koppel-Gates werden Schalter S eingefügt, die ein Abtrennen der Eingänge von den Koppel-Gates ermöglichen. Diese Schalter S werden durch ein Signal $\Phi_1$ gesteuert. Für weitere Erläuterungen soll bezüglich der Schalter S soll gelten, daß sie durch einen H-Pegel geschlossen und durch einen L-Pegel geöffnet werden. Des weiteren befinden sich an jedem Koppel-Gate, welches mit einem Eingang verbunden werden kann, weitere Schalter S', die durch ein Signal $\Phi_2$ gesteuert werden und über die das Potential der Koppel-Gates mit GND verbindbar ist. Über einen Schalter S1, der mit dem Signal $\Phi_1$ angesteuert wird, kann ein Drainknoten OUT,int des Transistors T20 mit dem Ausgang OUT der Schaltung und über einen Schalter S2, der ebenfalls mit dem Signal $\Phi_1$ angesteuert wird, kann der Drainknoten OUT,int des Transistors T20 mit dem Koppel-Gate mit der Wichtung $w_{OUT}$ verbunden werden. Der Knoten OUT,int kann ferner über einen durch das Signal $\Phi_2$ gesteuerten Schalter S3 mit dem Koppel-Gate mit der Wichtung $w_{ADJ}$ verbunden werden und ein weiterer durch as Signal $\Phi_2$ gesteuerter Schalter S4 kann das Koppel-Gate mit der Wichtung $w_{OUT}$ mit einer Spannungsquelle verbinden, die den Sollwert $V_{0,soll}$ der Nullpunktsspannung der Übertragungsfunktion liefert.

Wird die Schaltung nun mit dem ebenfalls im Schaltbild mit eingetragenen Taktschema für die Signale $\Phi_1$ und $\Phi_2$ betrieben, so hat die Schaltung während der Phasen, in denen $\Phi_1$ H-Pegel aufweist, die gewünschte Übertragungsfunktion. Während der Phasen, in denen das Signal $\Phi_2$ H-Pegel annimmt, wird die Übertragungsfunktion jedesmal aufs Neue wieder abgeglichen.

Der Abgleich geschieht dadurch, daß auf dem Koppel-Gate mit der Wichtung $w_{ADJ}$, bzw. auf der Kapazität, die sich aus der Parallelschaltung dieses Koppel-Gates und der Kapazität $C_{HELP}$ ergibt, ein bestimmter Potentialwert abgespeichert wird, der die Justierung der Übertragungsfunktion verursacht, wie weiter unten noch näher erläutert wird. Es ist notwendig, diesen Abgleich periodisch durchzuführen, da sich durch die Nicht-Idealität realer Schalter S die Ladung, die auf dem Koppel-Gate mit der Wichtung $w_{ADJ}$ einschließlich der optional vorhandenen parallelgeschalteten Kapazität $C_{HELP}$ befindet, durch Leckströme über den Schalter S, der dieses Koppel-Gate mit dem Knoten OUT,int verbindet, während des Betriebs der Schaltung ändern kann. Die Taktfrequenz der periodisch durchzuführenden Justierung richtet sich also nach der Qualität der Schalter bezüglicher ihrer Leckeigenschaften im ausgeschalteten Zustand und nach den Anforderungen an die Genauigkeit der gesamten Schaltung.

Die Übertragungsfunktion lautet für einen Zeitpunkt, bei dem $\Phi_2$ auf H-Pegel und $\Phi_1$ auf L-Pegel liegt

$$V_{OUT,int}(\Phi_2 = H) = \frac{1}{w_{ADJ}} \times V_0 - \frac{w_{OUT}}{w_{ADJ}} \times V_{0,soll} - \sum_{i=1}^{n} \frac{w_{IN,i}}{w_{ADJ}} \times V_{IN,i} \qquad (14)$$

Da die Koppel-Gates mit den Wichtungen $w_{IN,i}$, i=1 ... n, alle mit GND-Potential = 0 V verbunden sind, liefert die Summe in Gleichung (14) keinen Beitrag, so daß Gleichung (14) vereinfacht werden kann zu

$$V_{OUT,int}(\Phi_2 = H) = \frac{1}{w_{ADJ}} \times V_0 - \frac{w_{OUT}}{w_{ADJ}} \times V_{0,soll} \qquad (15)$$

Der Knoten, mit welchem das Koppel-Gate mit der Wichtung $w_{ADJ}$ verbunden ist, wird also auf die Spannung $V_{OUT,int}(\Phi_2=H)$ aufgeladen. Wenn nun $\Phi_2$ wieder L-Pegel annimmt, bleibt dieses Potential auf diesem Knoten erhalten. Wenn daraufhin $\Phi_1$ H-Pegel annimmt, hat die gesamte Stufe die Übertragungsfunktion

$$V_{OUT} = V_{OUT,int}(\Phi_1 = H) = \frac{1}{w_{OUT}} \times V_0 - \frac{w_{ADJ}}{w_{OUT}} \times V_{OUT,int}(\Phi_2 = H) - \sum_{i=1}^{n} \frac{w_{IN,i}}{w_{OUT}} \times V_{IN,i} \qquad (16)$$

Einsetzen von Gleichung (15) in Gleichung (16) ergibt bei der oben eingeführten Dimensionierung $w_{ADJ} = w_{OUT}$ die gewünschte Übetragungsfunktion:

$$V_{OUT}(\Phi_1 = H) = V_{0,soll} - \sum_{i=1}^{n} \frac{w_{IN,i}}{w_{OUT}} \times V_{IN,i} \qquad (17)$$

Der Vorteil der Ausbildung der erfindungsgemäßen Vorrichtung nach Figur 5 liegt darin, daß kein weiterer Referenz-Neuron-MOSFET T10,0 erforderlich ist, für den die Voraussetzung erfüllt sein muß, daß die prozeßbedingte Aufladung seines Floating-Gates exakt so groß ist wie die Aufladung der Floating-Gates der Neuron-MOSFETs in den eigentlichen Verstärkerstufen der Blöcke 1...k.

Neben der Voraussetzung, daß die prozeßbedingte Aufladung der Floating-Gates in den jeweiligen Referenzstufen exakt so groß ist wie die Aufladung der Floating-Gates der Neuron-MOSFETs in den eigentlichen Verstärkerstufen, muß für die Schaltungen gemäß Figur 3 und Figur 4 die Voraussetzung erfüllt sein, daß die Geometrien der Transistoren so weit wie möglich übereinstimmen. Aufgrund statistischer Schwankungen, die man als Matching-Fehler bezeichnet, sind geringfügige Unterschiede in den für die Transistoren charakteristischen Abmessungen trotz gleichen Layouts jedoch stets vorhanden. Auch in diesem Zusammenhang ist es bei der Schaltung gemäß Figur 5 von Vorteil, daß kein Referenz-Neuron-MOSFET zur Anwendung kommt und damit Matching-Probleme keine Rolle spielen können.

Eine Kombination, bei der eine Stufe, wie in Figur 5 gezeigt, durch Umschalten sowohl als Justierstufe als auch als Verstärkerstufe arbeitet und bei der weitere Verstärkerstufen, wie in Figur 3 oder 4 gezeigt, gleichzeitig mit justiert werden ist ebenfalls möglich.

In den Figuren 6 und 7 sind Ausführungsbeispiele für den Mehrfachstromspiegel SS von Figur 3 und 4 gezeigt, wobei in Figur 6 eine Detailschaltung eines einfachen Mehrfachstromspiegels und in Figur 7 jeweils eine Detailschaltung eines kaskadierten Mehrfachstromspiegels gezeigt ist. Diese beiden Schaltungen unterscheiden sich dadurch, daß die Schaltung gemäß Figur 7 einen wesentlich höheren Ausgangswiderstand hat und damit eine wesentlich geringere Abhängigkeit des Ausgangsstromes von der am Stromquellenausgang anliegenden Spannung besitzt als die Schaltung gemäß Figur 6, was sich günstig auf die Linearität der Verstärkerstufen auswirkt. Jedoch ist in der Schaltung gemäß Figur 6 der erforderliche Mindestspannungsabfall zwischen VDD und Ausgang geringer als in der Schaltung gemäß Figur 7, was wiederum die Aussteuerbarkeit der Verstärkerstufen erhöht.

Figur 8 zeigt eine Stromquellenschaltung mit einer beliebigen Anzahl von identischen Ausgängen. Anzumerken ist hierbei, daß in der Schaltung von Figur 8 ein Transistor mit "!" gekennzeichnet ist, dessen Transistorweite lediglich 0,1 bis 0,25 der sonst verwendeten Transistorweite beträgt.

Das Arbeitsprinzip dieser Schaltung bewirkt, daß sie zum einen einen recht großen Ausgangswiderstand besitzt, wobei der erforderliche Mindestspannungsabfall zwischen VDD und Ausgang jedoch wesentlich geringer ist als im Falle der Schaltung gemäß Figur 7. Ferner bedingt das Arbeitsprinzip dieser Schaltung jedoch auch, daß zwar alle Ausgangsströme identisch sind, daß sie jedoch nie ganz den Betrag des Eingangsstromes erreichen. Entsprechend der Diskussion der Funktion des Stromspiegels SS in der Schaltung gemäß Figur 4 bedeutet die letztgenannte Eigenschaft jedoch keine Einschränkung in diesem Fall, so daß sich die Schaltung gemäß Figur 8 aufgrund ihrer guten Eigenschaft, einen hohen Ausgangswiderstand mit einem geringem erforderlichem Mindestspannungsabfall zwischen VDD und Ausgang zu verknüpfen, hervorragend für den Einsatz in der Schaltung gemäß Figur 4 eignet.

Selbstverständlich ist es möglich, alle in den Figuren gezeigten Vorrichtungen auch komplementär aufzubauen, wobei die Anschlüsse VDD und VSS vertauscht und die verwendeten n-Kanal-Typen durch p-Kanal-Typen ersetzt werden müssen.

## Patentansprüche

1. Vorrichtung zur selbstjustierenden Arbeitspunkteinstellung in Verstärkerschaltungen mit Neuron-MOS-Transistoren,

   bei der eine Justierstufe (0) und mindestens eine dazu im wesentlichen gleich aufgebaute Verstärkerstufe (1...k) vorgesehen sind, die jeweils eine Reihenschaltung aus einem MOS-Feldeffekttransistor (T20,0...T20,k) und einem Neuron-MOS-Transistor (T10,0...T10,k) aufweisen, wobei alle Gates der MOS-Transistoren mit einer gemeinsamen Spannungsquelle (V20) verbunden sind,
   bei der die Justierstufe (0) und die mindestens eine Verstärkerstufe (1...k) so beschaltet sind, daß durch sie ein gleich großer Strom (I) fließt,
   bei der Eingangs-Gates ($w_{IN,1}..w_{IN,n}$) des zur Justierstufe gehörigen Neuron-MOS-Transistors (T10,0), die in der mindestens einen im wesentlichen gleich aufgebauten Verstärkerstufe Verstärkereingänge ( $IN_1$(T10,0)... $IN_n$(T10,0) ) darstellen, mit Bezugspotential (GND) verbunden sind und
   bei der ein Rückkoppel-Gate ($w_{OUT}$)des zur Justierstufe gehörigen Neuron-MOS-Transistors (T10,0), welches in der mindestens einen im wesentlichen gleich aufgebauten Verstärkerstufe auf einen Ausgang (OUT1... OUTk) der jeweiligen Verstärkerstufe rückgekoppelt ist, mit einer Spannungsquelle verbunden ist, die einen Sollwert ($V_{0,soll}$) für die Nullpunktsspannung ($V_0$) der mindestens einen Verstärkerstufe liefert.

2. Vorrichtung nach Anspruch 1,
   bei der ein gleich großer Strom in der Justierstufe (0) und in der mindestens einen Verstärkerstufe (1..k) dadurch erzeugt wird, daß ein Mehrfachstromspiegel (SS) mit einem Eingang (E) und mindestens einem Ausgang (A1...

Ak) vorgesehen ist und der Eingang des Mehrfachstromspiegels mit der Justierstufe sowie jeweils einer des mindestens einen Ausgangs des Mehrfachstromspiegels mit einer jeweiligen Verstärkerstufe verbunden sind.

3. Vorrichtung nach Anspruch 1,
bei der ein gleich großer Strom (I) in der Justierstufe (0) und in der mindestens einen Verstärkerstufe (1..k) dadurch erzeugt wird, daß ein Mehrfachstromspiegel (SS) oder eine Stromquellenschaltung mit einem Eingang (E), einem ersten Ausgang (A0) und mindestens einem weiteren Ausgang (A1...Ak) vorgesehen ist, daß der Eingang des Mehrfachstromspiegels oder der Stromquellenschaltung mit der einer Stromquelle (IO) verbunden ist, die den Strom (I) liefert, daß die Justierstufe mit dem ersten Ausgang des Mehrfachstromspiegels oder der Stromquellenschaltung und jeweils einer des mindestens einen weiteren Ausgangs des Mehrfachstromspiegels oder der Stromquellenschaltung mit einer jeweiligen Verstärkerstufe verbunden sind und bei der die Neuron-MOS-Transistoren der Justierstufe und der mindestens eine Verstärkerstufe ein ein zusätzliches Justier-Gate ($W_{ADJ}$) aufweisen das mit dem Ausgang (OUT0) der Justierstufe verbunden ist.

4. Vorrichtung nach Anspruch 1,
bei der eine der mindestens einen Verstärkerstufe mit Hilfe von elekronischen Schaltern (S, S', S1..S4) in regelmäßigen Zeitabständen als Justierstufe geschaltet ist, wobei die Eingangs-Gates des Neuron-MOS-Transistors (T10) wahlweise entweder auf Eingänge ($IN_1...IN_n$) der Verstärkerstufe oder auf Bezugspotential (GND) schaltbar sind, wobei ein Justier-Gate ($w_{ADJ}$) des Neuron-MOS-Transistors (T10) auf einen internen Ausgang (OUT,int) der Verstärkerstufe und ein Rückkoppel-Gate ($w_{OUT}$) auf eine Spannungsquelle mit dem Sollwert ($V_{0,soll}$) der Nullpunktsspannung schaltbar sind und wobei der interne Ausgang auf das Rückkoppelgate und auf einen externen Ausgang (OUT) der Vertärkerstufe schaltbar sind.

**Claims**

1. Device for self-aligning adjustment of the operating point in amplifier circuits with neuron MOS transistors, in the case of which an aligning stage (0) and at least one amplifier stage (1...k), constructed in a fashion essentially identical thereto, are provided, each of which has a series circuit composed of an MOS field effect transistor (T20,0...T20,k) and a neuron MOS transistor (T10,0...T10,k), all the gates of the MOS transistors being connected to a common voltage source (V20), in the case of which the aligning stage (0) and the at least one amplifier stage (1...k) are connected such that a current (I) of equal strength flows through them, in the case of which input gates ($w_{IN,1}...w_{IN,n}$) of the neuron MOS transistor (T10,0) belonging to the aligning stage, which represent amplifier inputs ($IN_1(T10, 0)...IN_n(T10,0)$) in the at least one amplifier stage constructed in an essentially identical fashion, are connected to reference potential (GND), and in the case of which a feedback gate (wouT) of the neuron MOS transistor (T10,0) belonging to the aligning stage, which feedback gate is fed back in the at least one amplifier stage constructed in an essentially identical fashion to an output (OUT1...OUTk) of the respective amplifier stage, is connected to a voltage source which supplies a desired value ($V_{0,soll}$) for the neutral voltage ($V_0$) of the at least one amplifier stage.

2. Device according to Claim 1, in the case of which a current of equal strength is produced in the aligning stage (0) and in the at least one amplifier stage (1...k) by virtue of the fact that a multiple current mirror (SS) with an input (E) and at least one output (A1...Ak) is provided, and the input of the multiple current mirror is connected to the aligning stage, and in each case one of the at least one output of the multiple current mirror is connected to a respective amplifier stage.

3. Device according to Claim 1, in the case of which a current (I) of equal strength is produced in the aligning stage (0) and in the at least one amplifier stage (1...k) by virtue of the fact that a multiple current mirror (SS) or a current source circuit with an input (E), a first output (A0) and at least one further output (A1...Ak) is provided, that the input of the multiple current mirror or the current source circuit is connected to the one current source (IO) which supplies the current (I), and that the aligning stage is connected to the first output of the multiple current mirror or the current source circuit, and in each case one of the at least one further output of the multiple current mirror or the current source circuit is connected to a respective amplifier stage, and in the case of which the neuron MOS transistors of the aligning stage and the at least one amplifier stage have an additional adjusting gate ($w_{ADJ}$) which is connected to the output (OUTO) of the aligning stage.

4. Device according to Claim 1, in the case of which one of the at least one amplifier stage is switched as aligning stage at regular time intervals with the aid of electronic switches (S, S', S1..S4), the input gates of the neuron MOS transistor (T10) being optionally switchable either to inputs ($IN_1..IN_n$) of the amplifier stage or to reference potential (GND), and an adjusting gate ($w_{ADJ}$) of the neuron MOS transistor (T10) being switchable to an internal output (OUT,int) of the amplifier stage, and a feedback gate ($w_{OUT}$) being switchable to a voltage source with the desired value ($V_{0, soll}$) of the neutral voltage, and the internal output being switchable to the feedback gate and to an external output (OUT) of the amplifier stage.

## Revendications

1. Dispositif pour le réglage du point de fonctionnement en auto-alignement dans des circuits amplificateurs avec transistors MOS-Neurones,

   dans lequel il est prévu un étage d'alignement (0) et au moins un étage amplificateur (1 à k) de structure sensiblement identique au précédent, qui comportent chacun un circuit série composé d'un transistor à effet de champ MOS (T20,0 à T20,k) et d'un transistor MOS-Neurones (T10,0 à T10,k), toutes les grilles des transistors MOS étant reliées à une source de tension commune (V20),
   dans lequel l'étage d'alignement (0) et le ou les étages amplificateurs (1 à k) sont branchés de telle sorte qu'un courant (I) de même intensité y passe à travers eux,
   dans lequel des grilles d'entrée ($w_{IN,1}$ à $w_{IN,n}$) du transistor MOS-Neurones (T10,0), associé à l'étage d'alignement, qui représentent des entrées d'amplificateurs ($IN_1$ (T10,0) à $IN_n$ (T10,0)) dans le ou les étages amplificateurs de structure sensiblement identique, sont reliées au potentiel de référence (GND) et
   dans lequel une grille de rétroaction ($w_{OUT}$) du transistor MOS-Neurones (T10,0), associé à l'étage d'alignement, qui est rebranchée sur une sortie (OUT1 à OUTk) de l'étage amplificateur respectif dans le ou les étages amplificateurs de structure sensiblement identique, est reliée à une source de tension qui fournit une valeur de consigne ($V_{0,soll}$) pour la tension au zéro ($V_0$) du ou des étages amplificateurs.

2. Dispositif selon la revendication 1,
   dans lequel un courant de même intensité dans l'étage d'alignement (0) et dans le ou les étages amplificateurs (1 à k) est produit par le fait qu'il est prévu un miroir de courant multiple (SS) avec une entrée (E) et avec au moins une sortie (A1 à Ak) et que l'entrée du miroir de courant multiple est reliée à l'étage d'alignement et à chaque fois une des sorties du miroir de courant multiple est reliée à un étage amplificateur respectif.

3. Dispositif selon la revendication 1,
   dans lequel un courant (I) de même intensité dans l'étage d'alignement (0) et dans le ou les étages amplificateurs (1 à k) est produit par le fait qu'il est prévu un miroir de courant multiple (SS) ou un circuit source de courant avec une entrée (E), avec une première sortie (A0) et avec au moins une autre sortie (A1 à Ak), que l'entrée du miroir de courant multiple ou du circuit source de courant est reliée à une source de courant (IO) qui fournit le courant (I), que l'étage d'alignement est relié à la première sortie du miroir de courant multiple ou du circuit source de courant et à chaque fois une des autres sorties du miroir de courant multiple ou du circuit source de courant est reliée à un étage amplificateur respectif et dans lequel les transistors MOS-Neurones de l'étage d'alignement et du ou des étages amplificateurs comportent une grille d'alignement supplémentaire ($w_{ADJ}$) qui est reliée à la sortie (OUTO) de l'étage d'alignement.

4. Dispositif selon la revendication 1,
   dans lequel un étage parmi le ou les étages amplificateurs est branché à intervalles de temps réguliers comme étage d'alignement à l'aide d'interrupteurs électroniques (S, S', S1 à S4), les grilles d'entrée du transistor MOS-Neurones (T10) étant commutables au choix soit sur des entrées ($IN_1$ à $IN_n$) de l'étage amplificateur soit sur le potentiel de référence (GND), une grille d'alignement ($w_{ADJ}$) du transistor MOS-Neurones (T10) étant commutable sur une sortie interne (OUT,int) de l'étage amplificateur, une grille de rétroaction ($w_{OUT}$) étant commutable sur une source de tension avec la valeur de consigne ($V_{0,soll}$) et la sortie interne étant commutable sur la grille de rétroaction et sur une sortie externe (OUT) de l'étage amplificateur.

# FIG 1

# FIG 2

$$\sum_{i=1}^{n} \frac{W_{IN,i}}{W_{OUT}} \times V_{IN,i}$$

$V_0 < 0\ V$

$$\sum_{i=1}^{n} \frac{W_{IN,i}}{W_{OUT}} \times V_{IN,i}$$

$V_0 = 0\ V$

$$\sum_{i=1}^{n} \frac{W_{IN,i}}{W_{OUT}} \times V_{IN,i}$$

$V_0 > 0\ V$

FIG 3

VDD

SS

E    A1    A2    Ak

OUT1    OUT2    OUTk

V20

$V_{0,soll}$

$W_{OUT}$

$IN_1(T10,0)$ $W_{IN,1}$
$IN_2(T10,0)$ $W_{IN,2}$    T10,0
$IN_3(T10,0)$ $W_{IN,3}$

$IN_{n-1}(T10,0)$ $W_{IN,n-1}$
$IN_n(T10,0)$ $W_{IN,n}$

T20,0    T20,1    T20,2    T20,k

$W_{OUT}$    $W_{OUT}$    $W_{OUT}$

$IN_1(T10,1)$ $W_{IN,1}$
$IN_2(T10,1)$ $W_{IN,2}$    T10,1
$IN_3(T10,1)$ $W_{IN,3}$

$IN_{n-1}(T10,1)$ $W_{IN,n-1}$
$IN_n(T10,1)$ $W_{IN,n}$

$IN_1(T10,2)$ $W_{IN,1}$
$IN_2(T10,2)$ $W_{IN,2}$    T10,2
$IN_3(T10,2)$ $W_{IN,3}$

$IN_{n-1}(T10,2)$ $W_{IN,n-1}$
$IN_n(T10,2)$ $W_{IN,n}$

$IN_1(T10,k)$ $W_{IN,1}$
$IN_2(T10,k)$ $W_{IN,2}$    T10,k
$IN_3(T10,k)$ $W_{IN,3}$

$IN_{n-1}(T10,k)$ $W_{IN,n-1}$
$IN_n(T10,k)$ $W_{IN,n}$

GND  GND    GND    VSS    0    VSS    1    VSS    2    VSS    k

EP 0 821 471 B1

12

FIG 4

FIG 5

EP 0 821 471 B1

FIG 6

VDD    VDD    VDD    VDD

IIN

IOUT1    IOUT2    IOUT3

VSS

FIG 7

VDD    VDD    VDD    VDD

IIN

IOUT1    IOUT2    IOUT3 . .

VSS

FIG 8

VDD    VDD    VDD    VDD    VDD

IIN

IOUT1    IOUT2    IOUT3 . . .

VSS    VSS

15